# EUROPEAN PATENT APPLICATION

(11) **EP 4 832 349 A1**
(43) Date of publication of application: **28.10.2026**
(21) Application number: 24905540.1
(22) Date of filing: 31.07.2024
(51) Int. Cl.: H03K 5/24

(54) **COMPARATOR CIRCUIT AND COMBINED COMPARATOR CIRCUIT**

(30) Priority: 20.12.2023 CN 202311769591
(71) Applicant: 3Peak Incorporated, Suzhou, Jiangsu 215100 (CN)
(72) Inventor: SHEN, Tianyu, Shanghai 200000 (CN)
(74) Representative: Winter, Brandl - Partnerschaft mbB
(86) International application number: PCT/CN2024/108857
(87) International publication number: WO 2025/130044

(57) **Abstract**

A comparator circuit is provided, comprising: a power supply voltage terminal; a reference voltage terminal; a first branch, electrically connected between the power supply voltage terminal and the reference voltage terminal, the first branch comprising a first N-type transistor and a first P-type transistor, the first N-type transistor comprising a gate configured to receive a first input voltage, a drain electrically connected to the power supply voltage terminal, and a source electrically connected to a first node, and the first P-type transistor comprising a gate configured to receive a second input voltage, a drain electrically connected to the reference voltage terminal, and a source electrically connected to the first node; a second branch, connected in parallel with the first branch between the power supply voltage terminal and the reference voltage terminal, the second branch providing a comparison current; and a current mirror circuit, electrically connected between the first branch and the second branch, wherein the current mirror circuit is configured to generate a mirrored output current on the second branch based on an input current on the first branch.

## Description

### TECHNICAL FIELD

The present disclosure relates to the field of integrated circuits, and in particular, to a comparator circuit and a combined comparator circuit.

### BACKGROUND

In low-power comparator applications, the comparator inputs do not typically toggle continuously, but rather receive a signal with a low toggling frequency (return-to-zero code), and in most cases, the input differential is zero. Currently, in many low-power scenarios (for example, an idle state), it is usually necessary to minimize the power consumption of a comparator. However, the response speed of the comparator is not fast enough, and even the power consumption of the comparator is not low enough.

### SUMMARY

Providing a mechanism that alleviates, mitigates, or even eliminates one or more of the above-mentioned problems will be advantageous.

According to one aspect of the present disclosure, a comparator circuit is provided, comprising: a power supply voltage terminal; a reference voltage terminal; a first branch, electrically connected between the power supply voltage terminal and the reference voltage terminal, the first branch comprising a first N-type transistor and a first P-type transistor, the first N-type transistor comprising a gate configured to receive a first input voltage, a drain electrically connected to the power supply voltage terminal, and a source electrically connected to a first node, and the first P-type transistor comprising a gate configured to receive a second input voltage, a drain electrically connected to the reference voltage terminal, and a source electrically connected to the first node; a second branch, connected in parallel with the first branch between the power supply voltage terminal and the reference voltage terminal, the second branch providing a comparison current; and a current mirror circuit, electrically connected between the first branch and the second branch, wherein the current mirror circuit is configured to generate a mirrored output current on the second branch based on an input current on the first branch.

According to another aspect of the present disclosure, a combined comparator circuit is provided, comprising: a first comparator, and a second comparator. Each of the first comparator and the second comparator comprises the comparator circuit as described above, wherein a gate of a first P-type transistor of the first comparator and a gate of a first N-type transistor of the second comparator are configured to receive a third input voltage, a gate of a first N-type transistor of the first comparator and a gate of a first P-type transistor of the second comparator are configured to receive a fourth input voltage, and a first output voltage terminal of the first comparator and a first output voltage terminal of the second comparator form a differential output terminal.

According to still another aspect of the present disclosure, a combined comparator circuit is provided, comprising: a first comparator, and a second comparator. Each of the first comparator and the second comparator comprises the comparator circuit as described above. The combined comparator circuit further comprises: a second OR gate circuit, comprising a third input terminal, a fourth input terminal, and a second output terminal, wherein the third input terminal is configured to receive a reset signal, and the second output terminal is electrically connected to a reset circuit input terminal of the first comparator; a third OR gate circuit, comprising a fifth input terminal, a sixth input terminal, and a third output terminal, wherein the fifth input terminal is configured to receive the reset signal, and the third output terminal is electrically connected to a reset circuit input terminal of the second comparator; a third falling edge pulse trigger, electrically connected between a second output voltage terminal of the first comparator and the sixth input terminal; and a fourth falling edge pulse trigger, electrically connected between a second output voltage terminal of the second comparator and the fourth input terminal. A gate of a first P-type transistor of the first comparator and a gate of a first N-type transistor of the second comparator are configured to receive a fifth input voltage, a gate of a first N-type transistor of the first comparator and a gate of a first P-type transistor of the second comparator are configured to receive a sixth input voltage, and a first output voltage terminal of the first comparator and a first output voltage terminal of the second comparator form a differential output terminal.

These and other aspects of the present disclosure will be apparent from and elucidated with reference to the embodiments described hereinafter.

### BRIEF DESCRIPTION OF DRAWINGS

More details, features, and advantages of the present disclosure are disclosed in the following description of exemplary embodiments with reference to the accompanying drawings. In the accompanying drawings:
FIG. 1 is a schematic circuit diagram illustrating a comparator according to an exemplary embodiment of the present disclosure;
FIG. 2 is a schematic circuit diagram illustrating a comparator comprising a reset circuit according to an exemplary embodiment of the present disclosure;
FIG. 3 is a schematic circuit diagram illustrating a comparator comprising current sources that limit dynamic circuits according to an exemplary embodiment of the present disclosure;
FIG. 4 is a schematic circuit diagram illustrating a variant of the comparator according to an exemplary embodiment of the present disclosure;
FIG. 5 is a schematic circuit diagram illustrating a variant of the comparator comprising the reset circuit according to an exemplary embodiment of the present disclosure;
FIG. 6 is a schematic circuit diagram illustrating a variant of the comparator comprising the current sources that limit the dynamic circuits according to an exemplary embodiment of the present disclosure;
FIG. 7 is a schematic circuit diagram illustrating a comparator comprising two output branches according to an embodiment of the present disclosure;
FIG. 8 is a schematic circuit diagram illustrating a comparator comprising a buffer according to an embodiment of the present disclosure;
FIG. 9 is a schematic output waveform diagram illustrating the comparator comprising the buffer according to an embodiment of the present disclosure;
FIG. 10 is a schematic circuit diagram illustrating a combined comparator according to another embodiment of the present disclosure;
FIG. 11 is a schematic circuit diagram illustrating a comparator with an additional current mirror circuit according to another embodiment of the present disclosure;
FIG. 12 is a schematic circuit diagram illustrating a combined comparator with an additional current mirror circuit according to another embodiment of the present disclosure;
FIG. 13 is a schematic circuit diagram illustrating a combined comparator according to still another embodiment of the present disclosure; and
FIG. 14 is a schematic circuit diagram illustrating a combined comparator with bias circuits according to still another embodiment of the present disclosure.

### DESCRIPTION OF EMBODIMENTS

It should be understood that, although the terms such as first, second, and third may be used herein to describe various elements, components, regions, layers, and/or portions, these elements, components, regions, layers, and/or portions should not be limited by these terms. These terms are only used to distinguish one element, component, region, layer, or portion from another. Therefore, a first element, component, region, layer, or portion discussed below may be referred to as a second element, component, region, layer, or portion without departing from the teachings of the present disclosure.

Spatial relative terms such as "under", "below", "lower", "underneath", "above", and "upper" may be used herein for ease of description to describe a relationship between one element or feature and another element(s) or feature(s) as illustrated in the figures. It should be understood that these spatial relative terms are intended to encompass different orientations of a device in use or operation, in addition to orientations depicted in the figures. For example, if a device in the figures is flipped over, an element described as "below another element or feature", "under another element or feature", or "underneath another element or feature" is oriented "above the another element or feature". Therefore, exemplary terms "below" and "underneath" may encompass both orientations of above and below. Terms such as "before" or "prior to" and "after" or "subsequent to" may be similarly used, for example, to indicate an order in which light passes through elements. The device may be oriented in other ways (rotated by 90 degrees or at other orientations), and spatial relative descriptors used herein should be interpreted accordingly. In addition, it should also be understood that when a layer is referred to as being "between two layers", the layer may be the only layer between the two layers, or one or more intermediate layers may also be present.

The terms used herein are merely for the purpose of describing particular embodiments and are not intended to limit the present disclosure. As used herein, the singular forms "a", "an", and "the" are intended to comprise the plural forms as well, unless the context clearly indicates otherwise. It should be further understood that the terms "comprise" and/or "contain", when used in this specification, specify the presence of stated features, entireties, steps, operations, elements, and/or components, but do not exclude the presence or addition of one or more other features, entireties, steps, operations, elements, components, and/or groups thereof. As used herein, the term "and/or" comprises any and all combinations of one or more of associated listed items, and the phrase "at least one of A or B" comprises only A, only B, and both A and B.

It should be understood that when an element or layer is referred to as being "on another element or layer", "connected to another element or layer", "coupled to another element or layer", or "adjacent to another element or layer", the element or layer may be directly on the another element or layer, directly connected to the another element or layer, directly coupled to the another element or layer, or directly adjacent to the another element or layer, or one or more intermediate layers may also be present. Conversely, when an element is referred to as being "directly on another element or layer", "directly connected to another element or layer", "directly coupled to another element or layer", or "directly adjacent to another element or layer", no intermediate elements or layers are present. However, in any case, "on" or "directly on" should not be construed as requiring one layer to completely cover an underlying layer.

Embodiments of the present disclosure are described herein with reference to schematic illustrations (and intermediate structures) of idealized embodiments of the present disclosure. Because of this, variations in illustrated shapes should be anticipated, for example, as a result of manufacturing technologies and/or tolerances. Therefore, the embodiments of the present disclosure should not be construed as being limited to specific shapes of regions illustrated herein, but should comprise shape deviations due to, for example, manufacturing. Therefore, the regions illustrated in the figures are schematic in nature, and the shapes of the regions are not intended to illustrate actual shapes of the regions of the device and are not intended to limit the scope of the present disclosure.

Unless otherwise defined, all terms (comprising technical terms and scientific terms) used herein have the same meaning as commonly understood by those of ordinary skill in the art to which the present disclosure belongs. It should be further understood that terms, such as those defined in commonly used dictionaries, should be interpreted as having meanings consistent with their meanings in the context of the related art and/or this specification, and will not be interpreted in an idealized or overly formal sense, unless expressly defined herein.

Exemplary embodiments of the present disclosure will be described in detail below, which may be used to obtain benefits for many reasons, for example, to alleviate or mitigate these undesirable side effects.

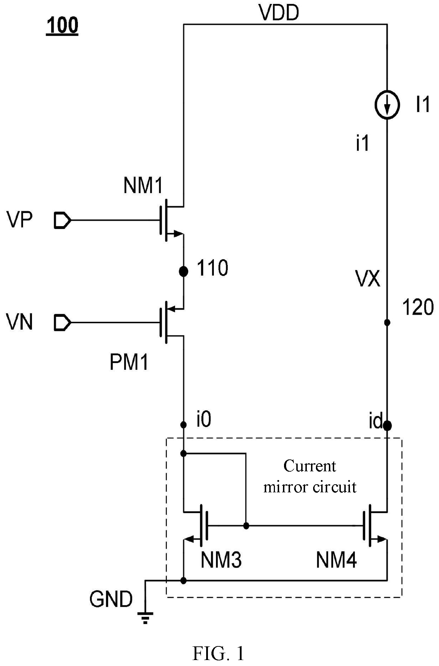

FIG. 1 is a schematic circuit diagram illustrating a comparator 100 according to an exemplary embodiment of the present disclosure. Referring to FIG. 1, the comparator circuit 100 comprises: a power supply voltage terminal VDD; a reference voltage terminal GND; a first branch, electrically connected between the power supply voltage terminal VDD and the reference voltage terminal GND, the first branch comprising a first N-type transistor NM1 and a first P-type transistor PM1, the first N-type transistor NM1 comprising a gate configured to receive a first input voltage VP, a drain electrically connected to the power supply voltage terminal VDD, and a source electrically connected to a first node 110, and the first P-type transistor PM1 comprising a gate configured to receive a second input voltage VN, a drain electrically connected to the reference voltage terminal GND, and a source electrically connected to the first node 110; a second branch, connected in parallel with the first branch between the power supply voltage terminal VDD and the reference voltage terminal GND, the second branch providing a comparison current i1; and a current mirror circuit, electrically connected between the first branch and the second branch, wherein the current mirror circuit is configured to generate a mirrored output current id on the second branch based on an input current i0 on the first branch.

In an example, when the comparator circuit 100 is in the static state, VP=VN. Since VP-VN=0V, which is less than the sum Vthp+Vthn of threshold voltages of NM1 and PM1, in this case, i0=id=0A, a voltage Vx at a second node 120 is at a high level, and the comparator generates almost no power consumption. When VP-VN>Vthp+Vthn, NM1 and PM1 are turned on, generating the current i0, wherein i0=id>0A. In this case, if id<i1, Vx is at the high level. When VP and VN are separated to a certain extent so that VP-VN>Vthp+Vthn and id>i1, Vx is at a low level, the comparator achieves output toggling, and power consumption is generated.

Accordingly, the comparator circuit generates almost no power consumption in the static state (for example, in an idle state), and can achieve fast triggering and reduce energy losses in the case of a low toggling signal frequency.

It should be understood that "NM1" and "PM1" in FIG. 1 may be metal oxide semiconductor (MOS) field-effect transistors, but this is only an example of the "first N-type transistor" and the "first P-type transistor". In another embodiment, the first N-type transistor and the first P-type transistor may be other types of field-effect transistors or transistors, such as junction field-effect transistors and bipolar junction transistors. The same applies to NM2 to NM6 and PM2 to PM6 as described below, and details are not provided herein.

It should be understood that a "GND" ground terminal in FIG. 1 is only an example of the "reference voltage terminal". In some embodiments, the reference voltage terminal may be a voltage terminal configured to receive a ground voltage, a negative power supply voltage, or a certain fixed potential.

Continuing to refer to FIG. 1, in the comparator circuit 100, the current mirror circuit comprises: a third N-type transistor NM3, comprising a source electrically connected to the reference voltage terminal GND, a gate electrically connected to the drain of the first P-type transistor PM1, and a drain electrically connected to the drain of the first P-type transistor PM1; and a fourth N-type transistor NM4, comprising a source electrically connected to the reference voltage terminal GND, a gate electrically connected to the drain of the first P-type transistor PM1, and a drain electrically connected to the second node 120.

In some examples, the current mirror circuit may be a common N-type MOS transistor current mirror circuit structure as shown in FIG. 1. In some other examples, the NM3 may also be replaced with a resistor, which can still achieve a function of generating the mirrored output current id on the second branch based on the input current i0 on the first branch.

In some embodiments, the comparator circuit 100 further comprises a reset circuit, wherein the reset circuit is electrically connected to the first branch and the second branch, and is configured to reset the comparator circuit 100.

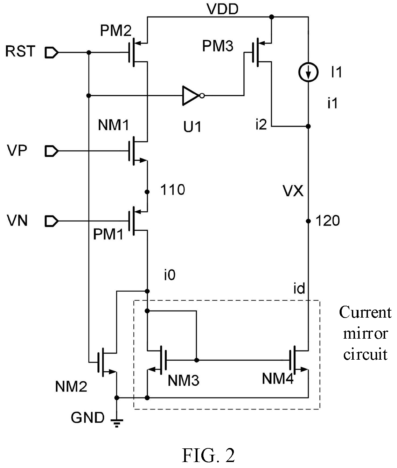

FIG. 2 is a schematic circuit diagram illustrating a comparator 100 comprising a reset circuit according to an exemplary embodiment of the present disclosure. Referring to FIG. 2, in the comparator circuit 100, the second branch comprises a first current source I1 to provide a comparison current i1, wherein the reset circuit comprises: a reset circuit input terminal configured to receive a reset signal RST; a second P-type transistor PM2, comprising a source electrically connected to the power supply voltage terminal VDD, a gate electrically connected to the reset circuit input terminal, and a drain electrically connected to the drain of the first N-type transistor NM1; a second N-type transistor NM2, comprising a source electrically connected to the reference voltage terminal GND, a gate electrically connected to the reset circuit input terminal, and a drain electrically connected between the drain of the first P-type transistor PM1 and the current mirror circuit; a third P-type transistor PM3, comprising a source electrically connected to the power supply voltage terminal VDD and a drain electrically connected to the second node 120, wherein the second node 120 is located between the first current source I1 and the current mirror circuit; and a first inverter U1, comprising an input terminal electrically connected to the reset circuit input terminal and an output terminal electrically connected to a gate of the third P-type transistor PM3.

In an example, after the reset circuit input terminal receives the reset signal RST (for example, a positive pulse or a high level), the gate voltage of PM2 is at a high level, and PM2 is cut off; and the gate voltage of NM2 is at a high level, and the gate voltage of PM3 is at a low level, NM2 and PM3 are turned on, i0=id=0A, a large current i2 is generated at the drain of PM3, so that i2+i1>id, and Vx is reset to a high level, thereby implementing comparator reset.

In some examples, the first current source I1 may be a resistor. A second current source I2 and a third current source I3 below may also be resistors.

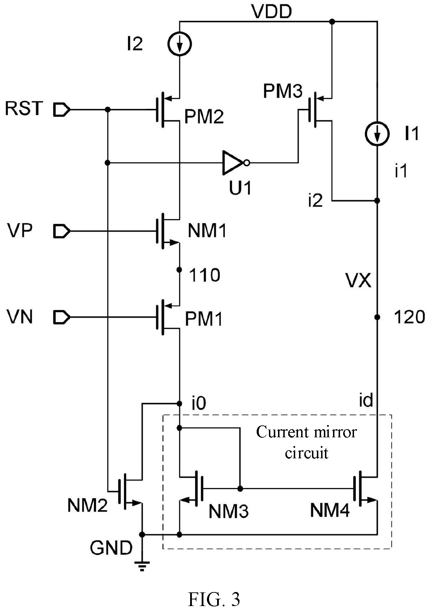

FIG. 3 is a schematic circuit diagram illustrating a comparator 100 comprising current sources that limit dynamic circuits according to an exemplary embodiment of the present disclosure. Referring to FIG. 3, the comparator circuit 100 further comprises: the second current source I2, electrically connected between the power supply voltage terminal VDD and the drain of the first N-type transistor NM1.

In an example, as shown in FIG. 3, since the comparator circuit 100 comprises a first reset circuit, the second current source I2 may be electrically connected between the power supply voltage terminal VDD and the source of the second P-type transistor PM2. The second current source I2 is configured to limit a dynamic current of the first branch, so as to protect devices such as NM1 and PM1 on the first branch.

In some examples, the second current source I2 may be replaced by a resistor.

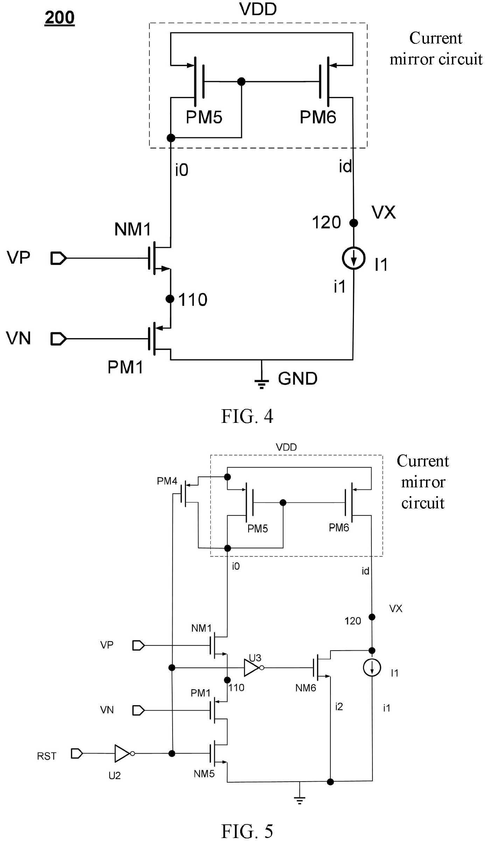

FIG. 4 is a schematic circuit diagram of a variant 200 of the comparator 100 according to an exemplary embodiment of the present disclosure. Referring to FIG. 4, the comparator circuit 200 comprises: a power supply voltage terminal VDD; a reference voltage terminal GND; a first branch, electrically connected between the power supply voltage terminal VDD and the reference voltage terminal GND, the first branch comprising a first N-type transistor NM1 and a first P-type transistor PM1, the first N-type transistor NM1 comprising a gate configured to receive a first input voltage VP, a drain electrically connected to the power supply voltage terminal VDD, and a source electrically connected to a first node 110, and the first P-type transistor PM1 comprising a gate configured to receive a second input voltage VN, a drain electrically connected to the reference voltage terminal GND, and a source electrically connected to the first node 110; a second branch, connected in parallel with the first branch between the power supply voltage terminal VDD and the reference voltage terminal GND, the second branch providing a comparison current i1; and a current mirror circuit, electrically connected between the first branch and the second branch, wherein the current mirror circuit is configured to generate a mirrored output current id on the second branch based on an input current i0 on the first branch.

In an example, when the comparator circuit 200 is in the static state, VP=VN. Since VP-VN=0V, which is less than the sum Vthp+Vthn of threshold voltages of NM1 and PM1, in this case, i0=id=0A<i1, a voltage Vx at a second node 120 is at a low level, and the comparator does not generate power consumption. When VP-VN>Vthp+Vthn, NM1 and PM1 are turned on, generating the current i0, wherein i0=id>0A. In this case, if id<i1, Vx is at the low level. When VP and VN are separated to a certain extent so that VP-VN>Vthp+Vthn and id>i1, Vx is at a high level, the comparator achieves output toggling, and power consumption is generated.

Continuing to refer to FIG. 4, different from the comparator circuit 100, in the comparator circuit 200, the current mirror circuit comprises: a fifth P-type transistor PM5, comprising a source electrically connected to the power supply voltage terminal VDD, a gate electrically connected to the drain of the first N-type transistor NM1, and a drain electrically connected to the drain of the first N-type transistor NM1; and a sixth P-type transistor PM6, comprising a source electrically connected to the power supply voltage terminal VDD, a gate electrically connected to the drain of the first N-type transistor NM1, and a drain electrically connected to the second node 120.

In some examples, the current mirror circuit may be a common P-type MOS transistor current mirror circuit structure as shown in FIG. 4. In some other examples, PM5 may also be replaced with a resistor, which can still achieve a function of generating the mirrored output current id on the second branch based on the input current i0 on the first branch.

FIG. 5 is a schematic circuit diagram illustrating a variant 200 of the comparator 100 comprising the reset circuit according to an exemplary embodiment of the present disclosure. Referring to FIG. 5, in the comparator circuit 200, the second branch comprises the first current source I1 to provide the comparison current i1, wherein the reset circuit comprises: the reset circuit input terminal, configured to receive the reset signal RST; a fifth N-type transistor NM5, comprising a source electrically connected to the reference voltage terminal GND and a drain electrically connected to the drain of the first P-type transistor PM1; a fourth P-type transistor PM4, comprising a source electrically connected to the power supply voltage terminal VDD and a drain electrically connected between the drain of the first N-type transistor NM1 and the current mirror circuit; a sixth N-type transistor NM6, comprising a source electrically connected to the reference voltage terminal GND and a drain electrically connected to the second node 120, the second node 120 being located between the first current source I1 and the current mirror circuit; a second inverter U2, comprising an input terminal electrically connected to the reset circuit input terminal and an output terminal electrically connected to a gate of the fifth N-type transistor NM5 and a gate of the fourth P-type transistor PM4; and a third inverter U3, comprising an input terminal electrically connected to the output terminal of the second inverter U2 and an output terminal electrically connected to a gate of the sixth N-type transistor NM6.

In an example, after the reset circuit input terminal receives the reset signal RST (for example, a positive pulse or a high level), the signal is transformed to a low level after passing through the second inverter U2, a gate voltage of NM5 is at a low level, and NM5 is cut off; and a gate voltage of PM4 is at a low level while a gate voltage of NM6 is at a high level, and PM4 and NM6 are turned on. In this case, i0=id=0A, a large current i2 is generated at the drain of NM6, so that i2+i1>id, and Vx is reset to a low level, thereby implementing comparator reset.

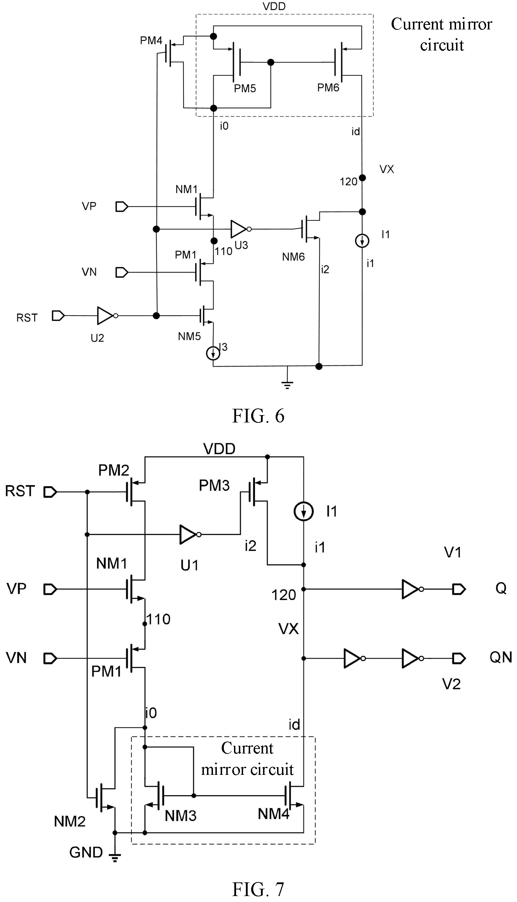

FIG. 6 is a schematic circuit diagram of a variant 200 of the comparator 100 comprising the current sources that limit the dynamic circuits according to an exemplary embodiment of the present disclosure. Referring to FIG. 6, the comparator circuit 200 further comprises: a third current source 13, and the third current source I3 is connected between the reference voltage terminal GND and the drain of the first P-type transistor PM1.

In an example, as shown in FIG. 6, since the comparator circuit 200 comprises a second reset circuit, wherein the third current source I3 may be electrically connected between the reference voltage terminal GND and the source of the fifth N-type transistor NM5. The third current source I3 is configured to limit the dynamic current of the first branch, so as to protect devices such as NM1 and PM1 on the first branch.

In some examples, the third current source I3 may be replaced by a resistor.

FIG. 7 is a schematic circuit diagram illustrating the comparator 100 or 200 comprising two output branches according to an embodiment of the present disclosure. Referring to FIG. 7, the comparator 100 or 200 comprising the reset circuit further comprises: a first output branch, comprising a first number of inverters connected in series with each other (one inverter in the figure), the first output branch being electrically connected between the second node 120 in the second branch and a first output voltage terminal Q, so as to output a first output voltage V1 at the first output voltage terminal Q; and a second output branch, comprising a second number of inverters connected in series with each other (two inverters in the figure), the second output branch being electrically connected between the second node 120 and a second output voltage terminal QN, so as to output a second output voltage V2 at the second output voltage terminal QN, and the second output voltage V2 being the inverse of the first output voltage V1.

It should be understood that although the "first number" in FIG. 7 is 1 and the "second number" is 2, the "first number" and the "second number" may be any number combination that causes the second output voltage V2 to be inverted relative to the first output voltage V1. In an embodiment, the "first number" or the "second number" may also be set to zero.

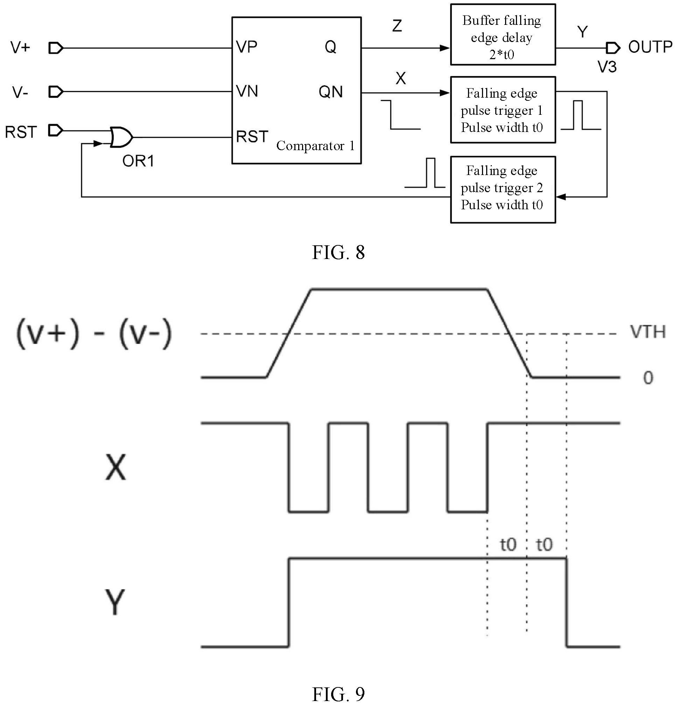

FIG. 8 is a schematic circuit diagram illustrating the comparator 100 or 200 comprising a buffer according to an embodiment of the present disclosure. Referring to FIG. 8, the comparator 100 or 200 comprising the reset circuit further comprises a first OR gate circuit OR1, comprising a first input terminal, a second input terminal, and a first output terminal, the first input terminal being configured to receive the reset signal RST, and the first output terminal being electrically connected to the reset circuit input terminal of the comparator circuit; a first buffer Buffer1, electrically connected between the first output voltage terminal Q and a third output voltage terminal OUTP, so as to output a third output voltage V3 at the third output voltage terminal OUTP; and a first falling edge pulse trigger and a second falling edge pulse trigger, connected in series between the second output voltage terminal QN and the second input terminal.

FIG. 9 is a schematic output waveform diagram illustrating the comparator 100 or 200 comprising the buffer according to an embodiment of the present disclosure. Referring to FIG. 9 in conjunction with FIG. 8, when (V+)-(V-)>VTH (VTH is a threshold voltage that satisfies id>i1+i2), QN toggles from a high level to a low level, and a reset signal with a width of t0 is generated after a time point t0 via the first falling edge pulse trigger and the second falling edge pulse trigger and fed to the second input terminal, so that QN toggles from a low level to a high level at the time point t0 and lasts for t0; at a time point 2*t0, (V+)-(V-) is still greater than VTH, and QN toggles from a high level to a low level again; and QN keeps toggling back and forth between high and low levels until (V+)-(V-)<VTH, and a waveform is shown as a waveform X in FIG. 9. Q is always phase-inverted with respect to QN, and therefore a waveform Z (not shown) is always phase-inverted with respect to the waveform X. After the waveform Z passes through the first buffer Buffer1, due to a 2*t0 delay in a falling edge of the first buffer Buffer1, the waveform Y remains at a high level when X toggles, and the waveform Y toggles to a low level for a duration of 2*t0 after X stops toggling.

Therefore, through an output of the comparator, a pulse reset is generated, which may respond to some narrow pulses when the power consumption is too low.

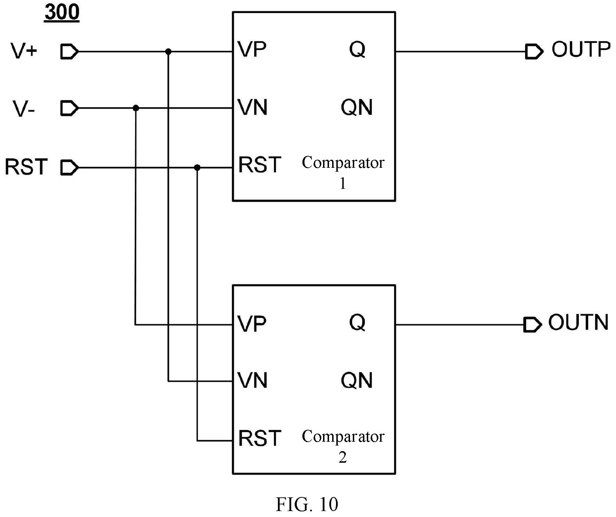

FIG. 10 is a schematic circuit diagram illustrating a combined comparator 300 according to another embodiment of the present disclosure. Referring to FIG. 10, the combined comparator circuit 300 comprises a first comparator and a second comparator. Each of the first comparator and the second comparator comprises the comparator circuit 100 or 200. A gate of a first P-type transistor of the first comparator and a gate of a first N-type transistor of the second comparator are configured to receive a third input voltage V-, a gate of a first N-type transistor of the first comparator and a gate of a first P-type transistor of the second comparator are configured to receive a fourth input voltage V+, and a first output voltage terminal of the first comparator and a first output voltage terminal of the second comparator form a differential output terminal comprising OUTP and OUTN.

In an example, when (V+)-(V-)>VTH, OUTP outputs a high level, and OUTN outputs a low level. When (V+)-(V-)<-VTH, OUTP outputs a low level, and OUTN outputs a high level. When -VTH<(V+)-(V-)<VTH, OUTP outputs a low level, and OUTN outputs a low level. Therefore, differential outputs of OUTP and OUTN form a three-state comparator.

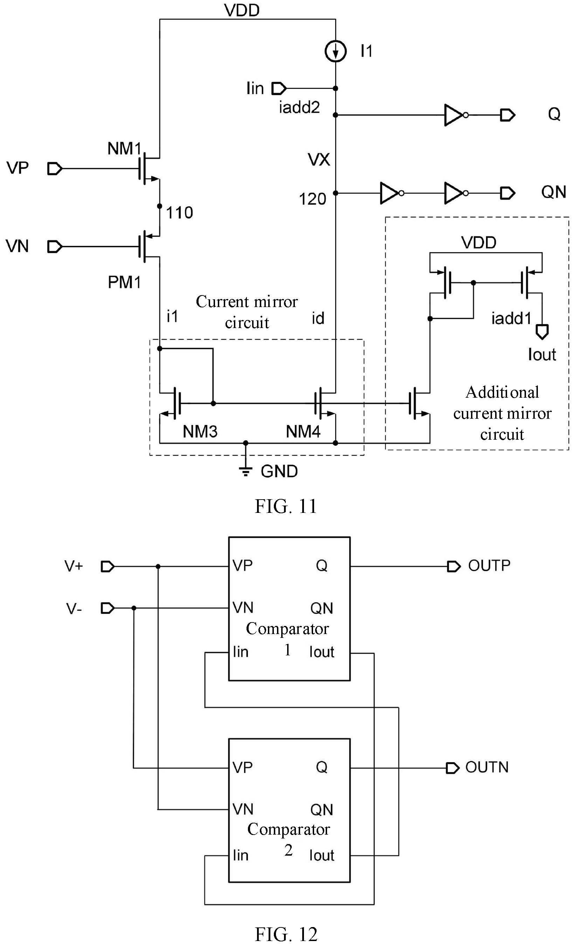

FIG. 11 is a schematic circuit diagram illustrating a comparator with an additional current mirror circuit according to another embodiment of the present disclosure. FIG. 12 is a schematic circuit diagram illustrating a combined comparator with an additional current mirror circuit according to another embodiment of the present disclosure. With reference to FIG. 11 and FIG. 12, in the combined comparator circuit 300, the first comparator further comprises a first additional current mirror circuit (as shown in FIG. 11). The first additional current mirror circuit is configured to generate a mirrored first additional output current Iadd1 based on an input current i1 on a first branch of the first comparator, and the first additional output current Iadd1 is fed between a current mirror circuit of the second comparator and a first current source in a second branch (Iin of a comparator 2 in FIG. 12). The second comparator further comprises a second additional current mirror circuit. The second additional current mirror circuit is configured to generate a mirrored second additional output current Iadd2 based on an input current (not shown) on a first branch of the second comparator, and the second additional output current Iadd2 is fed between a current mirror circuit of the first comparator and a first current source I1 in a second branch (Iin of a comparator 1 in FIG. 12).

Therefore, the first comparator and the second comparator may generate outputs by comparing the currents of the respective first branches.

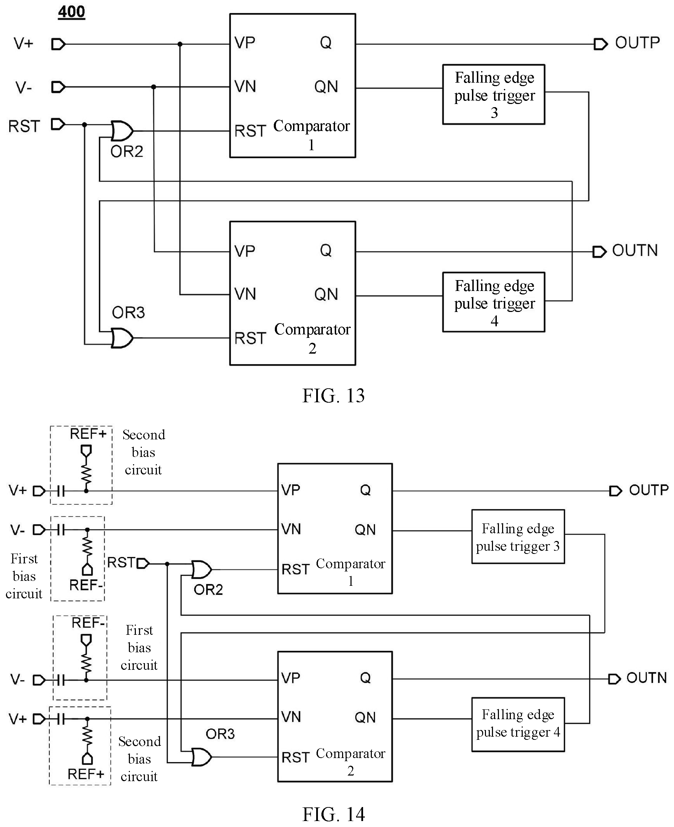

FIG. 13 is a schematic circuit diagram illustrating a combined comparator 400 according to still another embodiment of the present disclosure. Referring to FIG. 13, the combined comparator circuit 400 comprises a first comparator and a second comparator. Each of the first comparator and the second comparator comprises the comparator circuit 100 or 200 having two output branches. The combined comparator circuit further comprises: a second OR gate circuit OR2, comprising a third input terminal, a fourth input terminal, and a second output terminal, wherein the third input terminal is configured to receive the reset signal RST, and the second output terminal is electrically connected to a reset circuit input terminal of the first comparator; a third OR gate circuit OR3, comprising a fifth input terminal, a sixth input terminal, and a third output terminal, wherein the fifth input terminal is configured to receive the reset signal RST, and the third output terminal is electrically connected to a reset circuit input terminal of the second comparator; a third falling edge pulse trigger, electrically connected between a second output voltage terminal of the first comparator and the sixth input terminal; and a fourth falling edge pulse trigger, electrically connected between a second output voltage terminal of the second comparator and the fourth input terminal. The gate of the first P-type transistor of the first comparator and the gate of the first N-type transistor of the second comparator are configured to receive a fifth input voltage V-, the gate of the first N-type transistor of the first comparator and the gate of the first P-type transistor of the second comparator are configured to receive a sixth input voltage V+, and the first output voltage terminal OUTP of the first comparator and the first output voltage terminal OUTN of the second comparator form a differential output terminal.

The combined comparator shown in FIG. 10 can achieve fast triggering and slow reset. For example, when (V+)-(V-)>VTH, the comparator 1 can achieve fast triggering, while the comparator 2 resets slowly.

Referring again to FIG. 13, when (V+)-(V-)>VTH, QN of the comparator 1 outputs a falling edge, and a positive pulse is generated by the third falling edge pulse trigger and fed to the sixth input terminal, so as to implement fast reset of the comparator 2. Similarly, when (V+)-(V-)<-VTH, QN of the comparator 2 outputs a falling edge, and a positive pulse is generated by the fourth falling edge pulse trigger and fed to the fourth input terminal, so as to implement fast reset of the comparator 1.

Therefore, a pulse signal is generated by fast triggering of one of the two comparators, to rapidly reset the other comparator.

FIG. 14 is a schematic circuit diagram illustrating a combined comparator with bias circuits according to still another embodiment of the present disclosure. Referring to FIG. 14, the combined comparator circuit 400 further comprises: a first bias circuit electrically connected to the gate of the first P-type transistor of the first comparator and the gate of the first N-type transistor of the second comparator, and a second bias circuit electrically connected to the gate of the first P-type transistor of the second comparator and the gate of the first N-type transistor of the first comparator.

In an example, as shown in FIG. 14, the first bias circuit comprises a capacitor, a resistor, and an input terminal for receiving a REF-voltage; and the second bias circuit comprises a capacitor, a resistor, and an input terminal for receiving a REF+ voltage. By adjusting the REF+ voltage and the REF-voltage, a trigger threshold different from vthp+vthn may be obtained.

Although the present disclosure has been illustrated and described in detail in the accompanying drawings and the foregoing description, such illustration and description are to be considered illustrative and exemplary, rather than restrictive; and the present disclosure is not limited to the disclosed embodiments. By studying the accompanying drawings, the disclosure, and the appended claims, those skilled in the art can understand and implement variations of the disclosed embodiments when practicing the claimed subject matter. In the claims, the term "comprising" does not exclude other elements or steps not listed, the indefinite article "a" or "an" does not exclude a plurality, the term "plurality" means two or more, and the term "based on" should be construed as "at least partially based on". The mere fact that certain measures are recited in mutually different dependent claims does not indicate that a combination of these measures cannot be used to achieve beneficial effects.

## Claims

1. A comparator circuit, comprising:
a power supply voltage terminal;
a reference voltage terminal;
a first branch, electrically connected between the power supply voltage terminal and the reference voltage terminal, the first branch comprising a first N-type transistor and a first P-type transistor, the first N-type transistor comprising a gate configured to receive a first input voltage, a drain electrically connected to the power supply voltage terminal, and a source electrically connected to a first node, and the first P-type transistor comprising a gate configured to receive a second input voltage, a drain electrically connected to the reference voltage terminal, and a source electrically connected to the first node;
a second branch, connected in parallel with the first branch between the power supply voltage terminal and the reference voltage terminal, the second branch providing a comparison current; and
a current mirror circuit, electrically connected between the first branch and the second branch, wherein the current mirror circuit is configured to generate a mirrored output current on the second branch based on an input current on the first branch.

2. The comparator circuit according to claim 1, further comprising a reset circuit, wherein the reset circuit is electrically connected to the first branch and the second branch, and is configured to reset the comparator circuit.

3. The comparator circuit according to claim 2, wherein
the second branch comprises a first current source to provide the comparison current; and
the reset circuit comprises:
a reset circuit input terminal;
a second P-type transistor, comprising a source electrically connected to the power supply voltage terminal, a gate electrically connected to the reset circuit input terminal, and a drain electrically connected to the drain of the first N-type transistor;
a second N-type transistor, comprising a source electrically connected to the reference voltage terminal, a gate electrically connected to the reset circuit input terminal, and a drain electrically connected between the drain of the first P-type transistor and the current mirror circuit;
a third P-type transistor, comprising a source electrically connected to the power supply voltage terminal and a drain electrically connected to a second node, wherein the second node is located between the first current source and the current mirror circuit; and
a first inverter, comprising an input terminal electrically connected to the reset circuit input terminal and an output terminal electrically connected to a gate of the third P-type transistor.

4. The comparator circuit according to claim 3, wherein
the current mirror circuit comprises:
a third N-type transistor, comprising a source electrically connected to the reference voltage terminal, a gate electrically connected to the drain of the first P-type transistor, and a drain electrically connected to the drain of the first P-type transistor; and
a fourth N-type transistor, comprising a source electrically connected to the reference voltage terminal, a gate electrically connected to the drain of the first P-type transistor, and a drain electrically connected to the second node.

5. The comparator circuit according to claim 4, further comprising:
a second current source, electrically connected between the power supply voltage terminal and the drain of the first N-type transistor.

6. The comparator circuit according to claim 2, wherein
the second branch comprises a first current source to provide the comparison current; and
the reset circuit comprises:
a reset circuit input terminal;
a fifth N-type transistor, comprising a source electrically connected to the reference voltage terminal and a drain electrically connected to the drain of the first P-type transistor;
a fourth P-type transistor, comprising a source electrically connected to the power supply voltage terminal and a drain electrically connected between the drain of the first N-type transistor and the current mirror circuit;
a sixth N-type transistor, comprising a source electrically connected to the reference voltage terminal and a drain electrically connected to a second node, wherein the second node is located between the first current source and the current mirror circuit;
a second inverter, comprising an input terminal electrically connected to the reset circuit input terminal and an output terminal electrically connected to a gate of the fifth N-type transistor and a gate of the fourth P-type transistor; and
a third inverter, comprising an input terminal electrically connected to the output terminal of the second inverter and an output terminal electrically connected to a gate of the sixth N-type transistor.

7. The comparator circuit according to claim 6, wherein
the current mirror circuit comprises:
a fifth P-type transistor, comprising a source electrically connected to the power supply voltage terminal, a gate electrically connected to the drain of the first N-type transistor, and a drain electrically connected to the drain of the first N-type transistor; and
a sixth P-type transistor, comprising a source electrically connected to the power supply voltage terminal, a gate electrically connected to the drain of the first N-type transistor, and a drain electrically connected to the second node.

8. The comparator circuit according to claim 7, further comprising:
a third current source, wherein the third current source is connected between the reference voltage terminal and the drain of the first P-type transistor.

9. The comparator circuit according to any one of claims 2 to 8, further comprising:
a first output branch, comprising a first number of inverters connected in series with each other, wherein the first output branch is electrically connected between the second node in the second branch and a first output voltage terminal, so as to output a first output voltage at the first output voltage terminal; and
a second output branch, comprising a second number of inverters connected in series with each other, wherein the second output branch is electrically connected between the second node and a second output voltage terminal, so as to output a second output voltage at the second output voltage terminal, and the second output voltage is the inverse of the first output voltage.

10. The comparator circuit according to claim 9, further comprising:
a first OR gate circuit, comprising a first input terminal, a second input terminal, and a first output terminal, wherein the first input terminal is configured to receive a reset signal, and the first output terminal is electrically connected to the reset circuit input terminal of the comparator circuit;
a first buffer, electrically connected between the first output voltage terminal and a third output voltage terminal, so as to output a third output voltage at the third output voltage terminal; and
a first falling edge pulse trigger and a second falling edge pulse trigger, connected in series between the second output voltage terminal and the second input terminal.

11. A combined comparator circuit, comprising:
a first comparator; and
a second comparator, wherein each of the first comparator and the second comparator comprises the comparator circuit according to any one of claims 1 to 8, wherein
a gate of a first P-type transistor of the first comparator and a gate of a first N-type transistor of the second comparator are configured to receive a third input voltage,
a gate of a first N-type transistor of the first comparator and a gate of a first P-type transistor of the second comparator are configured to receive a fourth input voltage, and
a first output voltage terminal of the first comparator and a first output voltage terminal of the second comparator form a differential output terminal.

12. The combined comparator circuit according to claim 11, wherein
the first comparator further comprises a first additional current mirror circuit, the first additional current mirror circuit is configured to generate a mirrored first additional output current based on an input current on the first branch of the first comparator, and the first additional output current is fed between the current mirror circuit of the second comparator and the first current source in the second branch; and
the second comparator further comprises a second additional current mirror circuit, the second additional current mirror circuit is configured to generate a mirrored second additional output current based on an input current on the first branch of the second comparator, and the second additional output current is fed between a current mirror circuit of the first comparator and a first current source in the second branch.

13. A combined comparator circuit, comprising:
a first comparator; and
a second comparator, wherein each of the first comparator and the second comparator comprises the comparator circuit according to claim 9, and the combined comparator circuit further comprises:
a second OR gate circuit, comprising a third input terminal, a fourth input terminal, and a second output terminal, wherein the third input terminal is configured to receive a reset signal, and the second output terminal is electrically connected to a reset circuit input terminal of the first comparator;
a third OR gate circuit, comprising a fifth input terminal, a sixth input terminal, and a third output terminal, wherein the fifth input terminal is configured to receive the reset signal, and the third output terminal is electrically connected to a reset circuit input terminal of the second comparator;
a third falling edge pulse trigger, electrically connected between a second output voltage terminal of the first comparator and the sixth input terminal; and
a fourth falling edge pulse trigger, electrically connected between a second output voltage terminal of the second comparator and the fourth input terminal, wherein
a gate of a first P-type transistor of the first comparator and a gate of a first N-type transistor of the second comparator are configured to receive a fifth input voltage,
a gate of a first N-type transistor of the first comparator and a gate of a first P-type transistor of the second comparator are configured to receive a sixth input voltage, and
a first output voltage terminal of the first comparator and a first output voltage terminal of the second comparator form a differential output terminal.

14. The combined comparator circuit according to claim 13, further comprising:
a first bias circuit, electrically connected to the gate of the first P-type transistor of the first comparator and the gate of the first N-type transistor of the second comparator; and
a second bias circuit, electrically connected to the gate of the first P-type transistor of the second comparator and the gate of the first N-type transistor of the first comparator.
